# EUROPÄISCHE PATENTSCHRIFT

(11) **EP 2 858 849 B1**
(45) Veröffentlichungstag und Bekanntmachung des Hinweises auf die Patenterteilung: **10.07.2019**
(21) Anmeldenummer: 13727829.7
(22) Anmeldetag: 24.05.2013
(51) Int. Cl.: G01R 31/36, G01R 31/00

(54) **VERFAHREN ZUR BESTIMMUNG EINES OHMSCHEN INNENWIDERSTANDES EINES BATTERIEMODULS, BATTERIEMANAGEMENTSYSTEM UND KRAFTFAHRZEUG**
METHOD FOR DETERMINING THE INTERNAL OHMIC RESISTANCE OF A BATTERY MODULE, BATTERY MANAGEMENT SYSTEM AND MOTOR VEHICLE
PROCÉDÉ DE DÉTERMINATION D'UNE RÉSISTANCE INTERNE OHMIQUE D'UN MODULE DE BATTERIE, SYSTÈME DE GESTION DE BATTERIE ET VÉHICULE À MOTEUR

(30) Priorität: 08.06.2012 DE 102012209649
(43) Veröffentlichungstag der Anmeldung: 15.04.2015
(73) Patentinhaber: Robert Bosch GmbH, 70442 Stuttgart (DE); Samsung SDI Co., Ltd., Yongin-si, Gyeonggi-do 446-577 (KR)
(72) Erfinder: FINK, Holger, 70567 Stuttgart (DE)
(74) Vertreter: Bee, Joachim
(86) Internationale Anmeldenummer: PCT/EP2013/060760
(87) Internationale Veröffentlichungsnummer: WO 2013/182440

(56) Entgegenhaltungen:
- WO-A1-00/42690
- US-A- 4 044 300
- US-A1- 2011 234 166
- US-A1- 2011 234 231

## Beschreibung

Die vorliegende Erfindung betrifft ein Verfahren zur Bestimmung eines ohmschen Innenwiderstandes eines Batteriemoduls mit mindestens einer Batteriezelle, beispielsweise eine Lithium-Ionen-Batteriezelle, wie sie etwa in Traktionsbatterien von Elektro- oder Hybridkraftfahrzeugen, also in Kraftfahrzeugen mit zumindest teil- oder zeitweise elektrisch betriebenen Antrieben, Verwendung findet. Die Erfindung betrifft daher auch ein Kraftfahrzeug und ein Batteriemanagementsystem.

### Stand der Technik

Durch verbesserte Speicherkapazität, häufigere Wiederaufladbarkeit und höhere Energiedichten finden Batterien immer breitere Anwendungen. Batterien mit geringerer Energiespeicherkapazität werden zum Beispiel für kleine tragbare elektronische Geräte wie Mobiltelefone, Laptops, Camcordern und dergleichen verwendet, während Batterien mit hoher Kapazität als Energiequelle für den Antrieb von Motoren von Hybrid- oder Elektro-Fahrzeugen, etc. oder als stationäre Batterien Verwendung finden.

Batterien können zum Beispiel durch das serielle Verschalten von Batteriemodulen gebildet werden, wobei teilweise auch parallele Verschaltungen der Batteriemodule erfolgen und die Batteriemodule ihrerseits aus seriell und/oder parallel verschalteten Batteriezellen bestehen können.

Für den Antrieb von Motoren von Hybrid- oder Elektro-Fahrzeugen sind insbesondere Batteriemodulstränge geeignet, die auch als Batterie Converter (BDC) bezeichnet werden. Batteriemodulstränge umfassen mindestens zwei seriell geschaltete Batteriemodule, wobei weitere Batteriemodule parallel verschaltet sein können. Die Batteriemodule weisen dabei eine Kopplungseinheit auf und sind mit deren Hilfe individuell zu- und abschaltbar. Daher kann der Batteriemodulstrang durch entsprechendes Zu- und Abschalten der Module verwendet werden, einen oszillierenden Spannungsverlauf zu erzeugen. Bei entsprechender Auslegung kann zum Beispiel ein Spannungsprofil mit annähernd sinusförmigem Verlauf erzeugt werden, das zum Antrieb von Elektro- oder Hybridmotoren verwendbar ist.

Zum Batteriemanagement, zum Beispiel zur grundsätzlichen Ansteuerung von Modulen, zur Erhöhung der Sicherheit von Batterien, zur Effizienzsteigerung und zur Verlängerung der Lebenszeit von Batteriemodulen und aus Batteriemodulen zusammengesetzten Batteriesystemen werden Batteriemanagementsysteme eingesetzt. Eine Aufgabe von Batteriemanagementsystemen ist die Bestimmung des aktuellen Zustands der Batteriemodule. Zu den hierfür wichtigen Informationen zählt die Impedanz, der ohmsche Innenwiderstand des Batteriemoduls bzw. der im Batteriemodul enthaltenen Batteriezellen, wobei die Impedanz vom Ladungszustand, der Temperatur und dem Alterungsgrad der Batteriezellen abhängt.

Nach dem Stand der Technik erfolgen zugehörige Messungen außerhalb des Normalbetriebs der Batterie. Zum Beispiel wird in ISO 12405 vorgeschlagen, zu testende Batterien in einer Testumgebung für Zeiträume im Sekundenbereich mit pulsförmigen Lade- und Entladeströmen zu belegen und die Spannung an der Batterie vor und nach dem Strompuls zu messen. Die Impedanz ergibt sich dann als Verhältnis der Differenz der gemessenen Spannungen zur Stärke des Strompulses.

Da die Strompulse für eine oder mehrere Sekunden anliegen, liegen auch die beiden Spannungsmessungen um diesen Zeitraum auseinander.

Die Druckschrift WO 00/42690 A1 offenbart ein Batteriemanagementsystem für tragbare Geräte mit einem Mikroprozessor, welches eine vorbestimmte Spannung jeder Batteriezelle überwacht.

Die Druckschrift US 2001/234231 A offenbart ein Verfahren zur Berechnung eines Innenwiderstands zwischen der positiven Elektrode und der negativen Elektrode eines Batteriemoduls unter Berücksichtigung des Ladestroms und der Spannungsdifferenz.

Die Druckschrift US 2011/234166 A offenbart eine Zustandserfassung zum Messen eines Innenwiderstands einer Lithium-Eisenphosphat-Batterie, wobei die Zustandsermittlung den Innenwiderstand und die Entladezeit berücksichtigt.

Die Druckschrift US 4 044 300 A offenbart ein Verfahren zur Kontrolle einer Akkumulatorenbatterie, die aufgeladen und elektrolytgefüllt ist.

### Offenbarung der Erfindung

Erfindungsgemäß wird ein Verfahren nach Anspruch 1 zur Bestimmung eines ohmschen Innenwiderstandes eines Batteriemoduls aus Messungen von Spannungsstärken zur Verfügung gestellt. Das Batteriemodul ist dabei Teil eines Batteriemodulstrangs mit mindestens einem weiteren Batteriemodul.

Das Verfahren ist durch wiederholtes Zuschalten und Abschalten des Batteriemoduls zu dem mindestens einen weiteren Batteriemodul
gekennzeichnet, wobei das mindestens eine weitere Batteriemodul unter einem Laststrom steht und das Verfahren die Messung von Spannungsstärken des Batteriemoduls vor Zuschalten und nach dem Abschalten umfasst.

Dies ermöglicht eine Impedanzspektroskopie an einem Batteriemodul eines Batteriemodulstrangs im laufenden Betrieb.

In einer Ausführungsform erfolgt ein im Wesentlichen mit dem Zuschalten des Batteriemoduls gleichzeitiges Abschalten eines anderen Batteriemoduls, wobei das andere Batteriemodul so gewählt wird, dass zumindest eine von einer Ausgabespannung des Batteriemodulstrangs, einer Lade- oder Entladestromstärke des Batteriemodulstrangs und einer Temperatur des Batteriemodulstrangs durch das im Wesentlichen gleichzeitige Schalten unbeeinflusst ist.

Ein solches gleichzeitiges Zu- und Abschalten beeinflusst den laufenden Betrieb besonders wenig.

In einer anderen Ausführungsform erfolgt das wiederholte Zu- und Abschalten mit einer vorbestimmten Zeitdauer zwischen aufeinanderfolgenden Zuschaltungen und einer variierenden Zeitdauer zwischen einer Zuschaltung und einer darauffolgenden Abschaltung.

In einer weiteren anderen Ausführungsform erfolgt das wiederholte Zu- und Abschalten mit einer variierenden Zeitdauer zwischen aufeinanderfolgenden Zuschaltungen und einer vorbestimmten Zeitdauer zwischen einer Zuschaltung und einer darauffolgenden Abschaltung.

In noch einer weiteren anderen Ausführungsform erfolgt das wiederholte Zu- und Abschalten mit einer ersten variierenden Zeitdauer zwischen aufeinanderfolgenden Zuschaltungen und einer zweiten variierenden Zeitdauer zwischen einer Zuschaltung und einer darauffolgenden Abschaltung, wobei das Verhältnis von erster zu zweiter variierender Zeitdauer vorbestimmt ist.

Erfindungsgemäß wird weiterhin ein Batteriemanagementsystem für einen Batteriemodulstrang mit mindestens zwei zu- und abschaltbaren Batteriemodulen nach Anspruch 6 vorgestellt, wobei der Batteriemodulstrang eine Vorrichtung zur Messung von Batteriemodulspannungsstärken umfasst und weiterhin eine Vorrichtung zur Übermittlung gemessener Modulspannungsstärken an das Batteriemanagementsystem umfasst.

Das Batteriemanagementsystem ist ausgelegt, Änderungen der übermittelten Batteriemodulspannungsstärken eines der mindestens zwei Batteriemodule infolge wiederholten Zuschaltens und Abschaltens eines der mindestens zwei Batteriemodule zu mindestens einem unter einem Laststrom stehenden anderen der mindestens zwei Batteriemodule zu bestimmen und zur Bestimmung einer Impedanz des einen der mindestens zwei Batteriemodule zu verwenden, wobei Änderungen von Messungen von Spannungsstärken des Batteriemoduls vor dem Zuschalten und nach dem Abschalten bestimmt werden.

In einer Ausführungsform ist das Batteriemanagementsystem ausgelegt, Kopplungseinheiten der Batteriemodule des Batteriemodulstrangs so anzusteuern und die bestimmten Änderungen so weiterzuverarbeiten, dass ein ohmscher Innenwiderstand des einen Batteriemoduls nach einer der anderen Ausführungsformen des Verfahrens bestimmt wird.

Weiterhin wird ein Batteriemodulstrang mit dem vorgestellten Batteriemanagementsystem erfindungsgemäß vorgeschlagen. Schließlich wird noch ein Kraftfahrzeug mit dem vorgeschlagenen Batteriemodulstrang beansprucht.

Vorteilhafte Weiterbildungen der Erfindung sind in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein beispielhaftes Batteriemodul, an dem die Erfindung Verwendung finden kann;
Figur 2 einen beispielhaften Batteriemodulstrang, an dem die Erfindung Verwendung finden kann, und
Figur 3 ein Beispiel eines erfindungsgemäßen Systems aus Batteriemodulstrang und Batteriemanagementsystem.

### Ausführungsformen der Erfindung

Die vorliegende Erfindung wurde im Rahmen der Entwicklung eines BDC basierten, also Batteriemodulstrang basierten, Batteriesystems für ein Elektro- oder Hybridkraftfahrzeug gemacht und wird im Folgenden an diesem Ausführungsbeispiel beschrieben. Die Erfindung ist aber nicht auf dieses Ausführungsbeispiel beschränkt, sondern kann vorteilhaft in allen Batteriemodulsträngen aus mehreren Batteriemodulen verwendet werden, die ein Zu- und Abschalten unter Last erlauben. Insbesondere ist der Verwendungszweck des Batteriesystems für die Erfindung nicht von Belang.

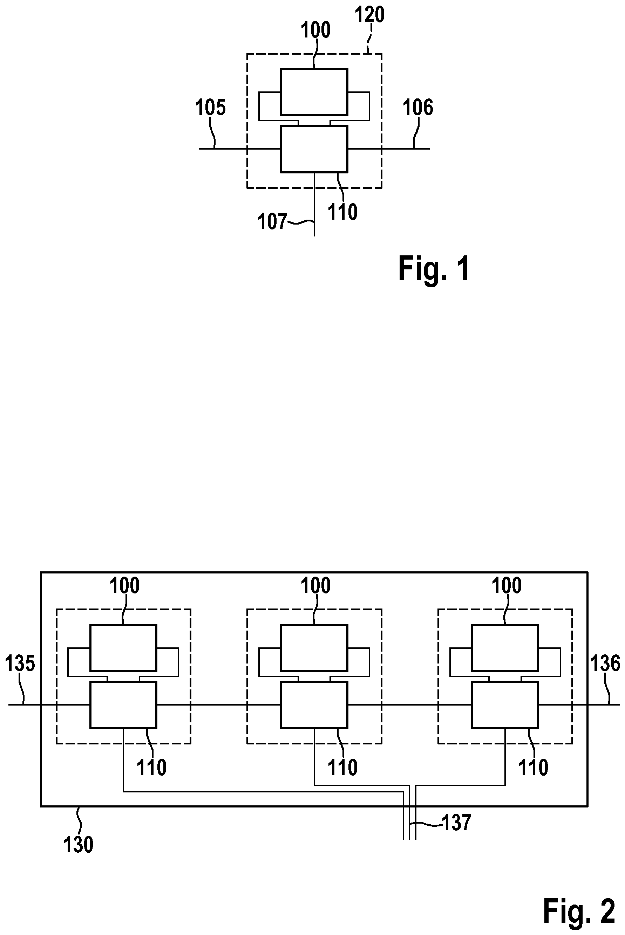

Figur 1 zeigt ein beispielhaftes Batteriemodul 100 mit einer Kopplungseinheit 110. Die Kopplungseinheit 110 ist entweder integraler Bestandteil des Batteriemoduls 100 oder, wie in Figur 1 gezeigt, Teil eines das Batteriemodul 100 umfassenden Systems 120. Die Kopplungseinheit 110 erlaubt es, das Batteriemodul 100 an- und abzuschalten, also zumindest von einem der auch Terminals genannten Pole 105 und 106 des Systems 120 zu trennen. Die Kopplungseinheit 110 des dargestellten Beispiels ist hierfür über einen Signaleingang 107 ansteuerbar. Es ist aber auch möglich, dass die Kopplungseinheit 110 mit einer vorbestimmten Frequenz das Modul ohne externe Ansteuerung zu- und abschaltet. Dadurch kann eine Rechteckspannung erzeugt werden.

Werden nun mehrere solche Module 100 oder Systeme 120 seriell in einem Batteriemodulstrang 130 angeordnet, wie in Figur 2 gezeigt, und zeitversetzt wiederholend zu- und abgeschaltet, so kann ein annähernd sinusförmiger Spannungsverlauf einer Spannung zwischen den Terminals 135 und 136 des Batteriemodulstrangs 130 erzeugt werden. Unter Last ergibt sich ein dem Spannungsverlauf entsprechender Stromverlauf.

In einem nicht gezeigten Ausführungsbeispiel werden alle in einem Strang zusammengefassten Module über eine einzige, gemeinsame Kopplungseinheit zu- und abgeschaltet. Diese kann ausgelegt sein, einen sinusförmigen oder im Wesentlichen rechteckigen Spannungsverlauf mit vorbestimmter Frequenz zu erzeugen. Oder es können Spannungsverläufe mit variabler Frequenz erzeugt werden, sofern eine Ansteuerungsmöglichkeit der gemeinsamen Kopplungseinheit zur Variierung der Frequenz besteht.

Unter Last erzeugt jede auch kurzfristige Zu- und Wiederabschaltung im zugeschalteten Batteriemodul 100 einen Stromstoß oder -puls, da der vor dem Zuschalten bereits durch den Strang 130 fließende Strom auch durch das zugeschaltete Modul 100 während der Zuschaltung fließt.

Infolge dieses Stromstoßes oder -pulses verändert sich die Modulspannung von in dem Modul 100 zusammengefassten Batteriezellen und damit auch die Spannung des Moduls 100. Der Zeitrahmen innerhalb dem diese Änderung erfolgt, ist dabei durch eine Dauer der Zuschaltung bestimmt und liegt deutlich unter einer Sekunde. Es wird daher eine genauere Messung einer Spannungsänderung möglich.

Insbesondere ist es möglich, das zu prüfende Modul wiederholt zu- und abzuschalten und so eine Messkurve mit mehreren Messpunkten zu erzeugen.

Dabei kann das wiederholte Zu- und Abschalten nach einem ersten Muster mit fester Zuschaltdauer und variierender Abschaltdauer erfolgen. Dabei ist die Zuschaltdauer die Zeit zwischen einer Zuschaltung und der unmittelbar nachfolgenden Abschaltung und die Abschaltdauer die Zeit zwischen einer Abschaltung und der unmittelbar nachfolgenden Zuschaltung. Dann wird die Frequenz gleichartiger Strompulse variiert.

Oder das wiederholte Zu- und Abschalten erfolgt nach einem zweiten Muster mit variierender Zuschaltdauer und fester Abschaltdauer. Dann werden die mit gleicher Frequenz erzeugten Strompulse in ihrer Breite variiert.

Es ist auch möglich, sowohl Zuschaltdauer als auch Abschaltdauer zu variieren, dabei aber das Verhältnis von Zuschaltdauer zu Abschaltdauer konstant zu halten. Dies erzeugt ein drittes Muster.

Mithilfe der Messung der Spannungsänderung am Modul 100 infolge des Zu- und Wiederabschaltens und der Stromstärke des während der Zuschaltung durch das Modul fließenden Stroms kann daher die Impedanz des zugeschalteten Moduls aus dem Verhältnis Spannungsänderung zu Stromstärke unter verschiedenen Messbedingungen bestimmt werden.

Diese Bestimmung ist also im laufenden Betrieb, unter Last, möglich. Sofern sich die gemessene Impedanz im Betrieb ändert, so ist dies ein Hinweis auf einen Alterungsprozess des betreffenden Moduls. Weiterhin ist es möglich, Sollimpedanzkurven zu den Zuschaltmustern in einer Speichereinheit eines Batteriemanagementsystems zu hinterlegen. Dann kann eine Abweichung einer bei einem gegebenen Zuschaltmuster aus Messungen bestimmten Impedanzkurve von der zu dem gegebenen Zuschaltmuster in der Speichereinheit hinterlegten Sollimpedanzkurve ein Hinweis für eine Veränderung von Batteriezellen in dem Modul sein.

Dabei ist es auch möglich, die Zuschaltung so zu gestalten, dass die zwischen Polen des Batteriestrangs anliegende Spannung sich nicht ändert, die Zuschaltung also spannungsinvariant ist. Zum Beispiel kann bei einer seriellen oder parallelen Zuschaltung eines zu prüfenden Moduls ein bisher entsprechend zugeschaltetes anderes Modul abgeschaltet werden. Wird dann das zu prüfende Modul wieder abgeschaltet, wird das andere Modul wieder zugeschaltet.

Es ist auch möglich, die Zuschaltung strominvariant zu gestalten. Dann wird der durch den Batteriestrang fließende Laststrom konstant gehalten. Schließlich ist es für Impedanzmessungen auch interessant, die Zuschaltung temperaturinvariant zu gestalten, da der ohmsche Innenwiderstand eines Batteriemoduls sich mit der Temperatur verändert.

Module können also zu auch Cluster genannten Modulpaaren zusammengefasst werden, wobei je Cluster ein Modul geprüft werden kann, während das andere Modul des jeweiligen Clusters zeitgleich, aber entgegengesetzt zum zu prüfenden Modul geschaltet wird.

Weiterhin kann, wenn Zuschaltungen von Modulen 100 zum Strang 130 unter verschiedenen Phasenlagen des Stroms, also bei unterschiedlichen Stromstärken, erfolgen, für eines, mehrere oder alle Module des Strangs 130 jeweils ein Impedanzprofil bestimmt werden. Sofern sich ein solches Impedanzprofil im Betrieb ändert, ohne dass sich die vorgegebene Zielleistung eines Verbrauchsgerätes geändert hätte, so ist dies ein Hinweis auf einen Alterungsprozess des betreffenden Moduls. Weiterhin ist es möglich, entsprechende Sollimpedanzprofile in der Speichereinheit zu hinterlegen. Wieder kann eine Abweichung des gemessenen Impedanzprofils vom Sollimpedanzprofil ein Hinweis für Modulalterung sein.

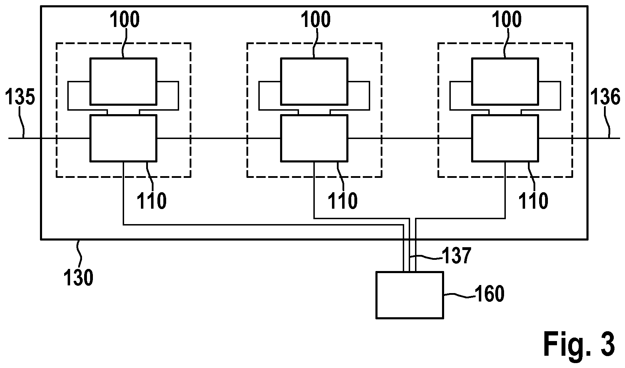

Figur 3 zeigt ein beispielhaftes Batteriemanagementsystem 160 im Zusammenspiel mit dem in Figur 2 gezeigten beispielhaften Strang 130. Das Batteriemanagementsystem 160 erfasst die von den Batteriemodulsträngen 130 dem Verbrauchsgerät zur Verfügung gestellten Spannungskurven und die fließenden Ströme und steuert über Verbindungen 137 zum Strang 130 die im Strang 130 angeordneten Module oder Systeme.

Die Erfindung erlaubt also eine quasi-kontinuierliche Überwachung der Modulzustände im laufenden Betrieb. Dies ermöglicht, Effizienzeinbußen oder gar Defekte von Modulen schnell und sicher zu erkennen. Dies ist vorteilhaft, weil die als defekt oder alternd erkannten Module ausgetauscht werden können und weil Störungen der durch den Batteriestrang bereitgestellten Leistung durch das defekte oder alternde Modul durch entsprechende Änderung der Ansteuerungen der Kopplungseinheiten zumindest teilweise kompensiert werden können.

## Patentansprüche

1. Verfahren zur Bestimmung eines ohmschen Innenwiderstandes eines Batteriemoduls (100), wobei das Verfahren die Bestimmung des ohmschen Innenwiderstandes aus Messungen von Spannungsstärken umfasst, **dadurch gekennzeichnet, dass**
das Verfahren wiederholtes Zuschalten und Abschalten des Batteriemoduls (100) zu mindestens einem weiteren unter einem Laststrom stehenden Batteriemodul (100) umfasst, wobei das mindestens eine weitere Batteriemodul (100) unter dem Laststrom steht und das Verfahren die Messung von Spannungsstärken des Batteriemoduls (100) vor dem Zuschalten und nach dem Abschalten umfasst.

2. Verfahren nach Anspruch 1, wobei das Batteriemodul (100) Teil eines Batteriemodulstrangs (130) mit mehreren weiteren Batteriemodulen (100) ist und ein im Wesentlichen mit dem Zuschalten des Batteriemoduls (100) gleichzeitiges Abschalten eines anderen Batteriemoduls (100) erfolgt, wobei das andere Batteriemodul (100) so gewählt wird, dass zumindest eine von einer Ausgabespannung des Batteriemodulstrangs (130), einer Lade- oder Entladestromstärke des Batteriemodulstrangs (130) und einer Temperatur des Batteriemodulstrangs (130) durch das im Wesentlichen gleichzeitige Schalten unbeeinflusst ist.

3. Verfahren nach Anspruch 1 oder 2, wobei das wiederholte Zu- und Abschalten mit einer vorbestimmten Zeitdauer zwischen aufeinanderfolgenden Zuschaltungen und einer variierenden Zeitdauer zwischen einer Zuschaltung und einer darauffolgenden Abschaltung erfolgt.

4. Verfahren nach Anspruch 1 oder 2, wobei das wiederholte Zu- und Abschalten mit einer variierenden Zeitdauer zwischen aufeinanderfolgenden Zuschaltungen und einer vorbestimmten Zeitdauer zwischen einer Zuschaltung und einer darauffolgenden Abschaltung erfolgt.

5. Verfahren nach Anspruch 1 oder 2, wobei das wiederholte Zu- und Abschalten mit einer ersten variierenden Zeitdauer zwischen aufeinanderfolgenden Zuschaltungen und einer zweiten variierenden Zeitdauer zwischen einer Zuschaltung und einer darauffolgenden Abschaltung erfolgt, wobei das Verhältnis von erster zu zweiter variierender Zeitdauer vorbestimmt ist.

6. Batteriemanagementsystem (160) für einen Batteriemodulstrang (130) mit mindestens zwei zu- und abschaltbaren Batteriemodulen (100), wobei der Batteriemodulstrang (130) eine Vorrichtung zur Messung von Batteriemodulspannungsstärken unter Last umfasst und weiterhin eine Vorrichtung zur Übermittlung gemessener Modulspannungsstärken an das Batteriemanagementsystem umfasst, **dadurch gekennzeichnet, dass** das Batteriemanagementsystem (160) ausgelegt ist, Änderungen der übermittelten Batteriemodulspannungsstärken eines der mindestens zwei Batteriemodule (100) infolge wiederholten Zuschaltens und Abschaltens eines der mindestens zwei Batteriemodule (100) zu mindestens einem unter einem Laststrom stehenden anderen der mindestens zwei Batteriemodule (100) zu bestimmen und zur Bestimmung einer Impedanz des einen der mindestens zwei Batteriemodule (100) zu verwenden, wobei Änderungen von Messungen von Spannungsstärken des Batteriemoduls (100) vor dem Zuschalten und nach dem Abschalten bestimmt werden.

7. Batteriemanagementsystem (160) nach Anspruch 6, wobei das Batteriemanagementsystem (160) ausgelegt ist, Kopplungseinheiten der Batteriemodule (100) des Batteriemodulstrangs (130) so anzusteuern und die bestimmten Änderungen so weiterzuverarbeiten, dass ein ohmscher Innenwiderstand des einen Batteriemoduls (100) nach dem Verfahren nach einem der Ansprüche 2 bis 5 bestimmt wird.

8. Batteriemodulstrang (130) mit einem Batteriemanagementsystem (160) nach Anspruch 6 oder 7 und mit mindestens zwei zu- und abschaltbaren Batteriemodulen (100).

9. Kraftfahrzeug mit einem Batteriemodulstrang (130) nach Anspruch 8.

## Claims

1. Method for determining an internal ohmic resistance of a battery module (100), wherein the method comprises determining the internal ohmic resistance from measurements of voltage intensities, **characterized in that**
the method comprises repeatedly connecting and disconnecting the battery module (100) to and from at least one further battery module (100) which is under a load current, wherein the at least one further battery module (100) is under the load current, and the method comprises measuring voltage intensities of the battery module (100) prior to the connection and after the disconnection.

2. Method according to Claim 1, wherein the battery module (100) is part of a battery module string (130) comprising a plurality of further battery modules (100), and, substantially simultaneously with the connection of the battery module (100), disconnection of another battery module (100) takes place, wherein the other battery module (100) is selected such that at least one of an output voltage of the battery module string (130), a charging or discharging current intensity of the battery module string (130) and a temperature of the battery module string (130) is uninfluenced by the substantially simultaneous switching.

3. Method according to Claim 1 or 2, wherein the repeated connection and disconnection takes place with a predetermined time period between successive connections and a varying time period between a connection and a subsequent disconnection.

4. Method according to Claim 1 or 2, wherein the repeated connection and disconnection takes place with a varying time period between successive connections and a predetermined time period between a connection and a subsequent disconnection.

5. Method according to Claim 1 or 2, wherein the repeated connection and disconnection takes place with a first varying time period between successive connections and a second varying time period between a connection and a subsequent disconnection, wherein the ratio of the first to the second varying time periods is predetermined.

6. Battery management system (160) for a battery module string (130) comprising at least two connectable and disconnectable battery modules (100), wherein the battery module string (130) comprises an apparatus for measuring battery module voltage intensities under load and furthermore comprises an apparatus for transmitting measured module voltage intensities to the battery management system, **characterized in that** the battery management system (160) is configured to determine changes in the transmitted battery module voltage intensities of one of the at least two battery modules (100) as a result of repeated connection and disconnection of one of the at least two battery modules (100) to and from at least one other of the at least two battery modules (100) which is under a load current and to use these changes to determine an impedance of one of the at least two battery modules (100), wherein changes in measurements of voltage intensities of the battery module (100) prior to connection and after disconnection are determined.

7. Battery management system (160) according to Claim 6, wherein the battery management system (160) is configured to actuate coupling units of the battery modules (100) of the battery module string (130) and to further-process the determined changes in such a way that an internal ohmic resistance of one battery module (100) is determined in accordance with the method according to one of Claims 2 to 5.

8. Battery module string (130) comprising a battery management system (160) according to Claim 6 or 7 and comprising at least two connectable and disconnectable battery modules (100).

9. Motor vehicle comprising a battery module string (130) according to Claim 8.

## Revendications

1. Procédé de détermination de la résistance interne ohmique d'un module de batterie (100), le procédé comprenant la détermination de la résistance interne ohmique à partir de mesures d'amplitudes de tension, **caractérisé en ce que**
le procédé comprenant la connexion et la déconnexion répétées du module de batterie (100) à un/d'au moins un module de batterie (100) supplémentaire qui se trouve sous un courant de charge, l'au moins un module de batterie (100) supplémentaire se trouvant sous le courant de charge et le procédé comprenant la mesure d'amplitudes de tension du module de batterie (100) avant la connexion et après la déconnexion.

2. Procédé selon la revendication 1, le module de batterie (100) faisant partie d'une chaîne de modules de batterie (130) comprenant plusieurs modules de batterie (100) supplémentaires et une déconnexion d'un autre module de batterie (100) ayant lieu sensiblement simultanément avec la connexion du module de batterie (100), l'autre module de batterie (100) étant choisi de telle sorte qu'au moins une grandeur parmi une tension de sortie de la chaîne de modules de batterie (130), une intensité de courant de charge ou de décharge de la chaîne de modules de batterie (130) et une température de la chaîne de modules de batterie (130) n'est pas influencée par la commutation sensiblement simultanée.

3. Procédé selon la revendication 1 ou 2, les connexion et déconnexion répétées s'effectuant avec une durée prédéterminée entre les connexions successives et une durée variable entre une connexion et une déconnexion qui suit.

4. Procédé selon la revendication 1 ou 2, les connexion et déconnexion répétées s'effectuant avec une durée variable entre les connexions successives et une durée prédéterminée entre une connexion et une déconnexion qui suit.

5. Procédé selon la revendication 1 ou 2, les connexion et déconnexion répétées s'effectuant avec une première durée variable entre les connexions successives et une deuxième durée variable entre une connexion et une déconnexion qui suit, le rapport entre les première et deuxième durées variables étant prédéterminé.

6. Système de gestion de batterie (160) pour une chaîne de modules de batterie (130) comprenant au moins deux modules de batterie (100) pouvant être connectés et déconnectés, la chaîne de modules de batterie (130) comprenant un dispositif de mesure des amplitudes de tension de module de batterie en charge et comprenant en outre un dispositif de communication des amplitudes de tension de module mesurées au système de gestion de batterie, **caractérisé en ce que** le système de gestion de batterie (160) est conçu pour déterminer les variations des amplitudes de tension de module de batterie communiquées de l'un des au moins deux modules de batterie (100) résultant d'une connexion et d'une déconnexion répétées de l'un des au moins deux modules de batterie (100) à un/d'au moins un autre des au moins deux modules de batterie (100) qui se trouve sous un courant de charge et l'utiliser pour déterminer une impédance dudit un des au moins deux modules de batterie (100), les variations des mesures des amplitudes de tension du module de batterie (100) étant déterminées avant la connexion et après la déconnexion.

7. Système de gestion de batterie (160) selon la revendication 6, le système de gestion de batterie (160) étant conçu pour commander les unités d'accouplement des modules de batterie (100) de la chaîne de modules de batterie (130) et pour traiter les modifications déterminées de telle sorte qu'une résistance interne ohmique dudit module de batterie (100) est déterminée conformément à un procédé selon l'une des revendications 2 à 5.

8. Chaîne de modules de batterie (130) comprenant un système de gestion de batterie (160) selon la revendication 6 ou 7 et comprenant au moins deux modules de batterie (100) pouvant être connectés et déconnectés.

9. Véhicule automobile comprenant une chaîne de modules de batterie (130) selon la revendication 8.
